# EUROPÄISCHE PATENTSCHRIFT

(11) **EP 0 300 560 B1**
(45) Veröffentlichungstag und Bekanntmachung des Hinweises auf die Patenterteilung: **29.09.1993**
(21) Anmeldenummer: 88201502.7
(22) Anmeldetag: 13.07.1988
(51) Int. Cl.: G01R 19/00, H03K 5/24

(54) **Vergleichsschaltung**
Comparison circuit
Circuit de comparison

(30) Priorität: 18.07.1987 DE 3723919
(43) Veröffentlichungstag der Anmeldung: 25.01.1989
(73) Patentinhaber: Philips Patentverwaltung GmbH, 22335 Hamburg (DE); Philips Electronics N.V., 5621 BA Eindhoven (NL)
(72) Erfinder: Klose, Hans-Peter, D-2083 Halstenbek (DE); König, Kurt, D-2000 Hamburg 60 (DE); Schwartz, Wolfgang, D-2000 Hamburg 65 (DE)
(74) Vertreter: Poddig, Dieter, Dipl.-Ing.

(56) Entgegenhaltungen:
- US-A- 4 197 472
- US-A- 4 450 368
- International Journal of Electronics vol. 64, no. 3, März 1988, London GB Seiten 409 - 415; Ch.Ph.Chong et.al.: "A high-resolution CMOS comparator"
- ELECTRONICS LETTERS. vol. 22, no. 6, 13 März 1986, ENAGE GB Seiten 338 - 339; W.T.Ng et.al.: "High-speed high-resolution CMOS voltage comparator"

## Beschreibung

Die Erfindung bezieht sich auf eine Vergleichsschaltung in MOS-Technik zum Vergleich zweier Eingangsspannungen mittels eines Differenzverstärkers,
- dessen erstem Eingang über einen ersten Kondensator mittels einer Schalteranordnung während einer ersten Zeitdauer eine erste Eingangsspannung und während einer auf die erste Zeitdauer folgenden zweiten Zeitdauer eine zweite Eingangsspannung zugeführt wird,
- dessen zweiter Eingang an einer Bezugsspannung liegt und
- dessen Ausgang während der ersten Zeitdauer mit dem ersten Eingang verbunden ist.

Eine derartige Vergleichsschaltung wird beispielsweise in Analog-Digital-Umsetzern verwendet, die nach dem Prinzip der sukzessiven Approximation arbeiten. Ein solcher Analog-Digital-Umsetzer besteht des weiteren aus einem Digital-Analog-Umsetzer und einer Steuerschaltung, die das digitale Ausgangssignal liefert. Die Steuerschaltung setzt zu Beginn eines Umsetzungsprozesses das höchstwertige Bit, welches digital-analog-umgesetzt wird und in der Vergleichsschaltung mit dem analogen Eingangssignal verglichen wird. Ist das digital-analog-umgesetzte Vergleichssignal kleiner als das analoge Eingangssignal, bleibt das höchstwertige Bit gesetzt, ist es größer, wird es zurückgesetzt. Der Vergleich wird sukzessive mit dem nächsten Bit wiederholt. Auf diese Weise wird schrittweise das digitale Ausgangssignal dem analogen Eingangssignal angenähert.

Die eingangs genannte Vergleichsschaltung ist aus der Zeitschrift "Markt & Technik", Nr. 9 vom 01.03.1985, Seite 76, bekannt. Während der ersten Zeitdauer liegt an dem ersten Kondensator die Differenz der ersten Eingangsspannung und der Spannung an, die am ersten Eingang des Differenzverstärkers erzeugt wird, wenn der Ausgang und der erste Eingang verbunden sind. Das Verbinden des Ausganges mit dem ersten Eingang des Differenzverstärkers dient zur Arbeitspunkteinstellung des Differenzverstärkers. Während der zweiten Zeitdauer liegt am Eingang des Differenzverstärkers die Summe aus der zweiten Eingangsspannung und der Spannung an, die sich am ersten Kondensator während der ersten Zeitdauer eingestellt hat. Der Differenzverstärker erzeugt eine Ausgangsspannung in Abhängigkeit von der Spannung am ersten Eingang. Die Ausgangsspannung des Differenzverstärkers weist einen hohen oder niedrigen Spannungszustand auf.

Die Schalteranordnung der Vergleichsschaltung, die aus zwei parallel geschalteten Schaltern besteht, ist durch MOS-Feldeffekttransistoren realisiert. Solche Transistoren bilden keinen idealen Schalter. Während die Schalter geschlossen sind (die Transistoren sind leitend) wird im Kanal des jeweiligen Transistors eine Ladung gespeichert. Wenn der Schalter geöffnet ist (die Transistoren sind gesperrt) fließt die im Kanal gespeicherte Ladung ab. In der Vergleichsschaltung wird durch den Ladungsabfluß des ersten Schalters eine zusätzliche Ladung auf den ersten Kondensator gegeben. Aufgrund dieser zusätzlichen Ladung kann ein fehlerhafter Spannungsvergleich vorliegen, insbesondere bei zu vergleichenden Spannungen, die wenig voneinander abweichen. Im Ausgangssignal des Differenzverstärkers liegt nämlich dann statt eines hohen bzw. niedrigen Signalzustandes ein niedriger bzw. hoher Signalzustand vor. Hierdurch wird bei der Analog-Digital-Umsetzung ein Digitalsignal erzeugt, dessen Wert nicht genau dem analogen Eingangssignal entspricht.

Der Erfindung liegt die Aufgabe zugrunde, eine Vergleichsschaltung der eingangs genannten Art zu schaffen, bei der der Ladungsverlust des ersten Schalters keine Auswirkungen auf den Vergleich hat.

Die Aufgabe wird erfindungsgemäß dadurch gelöst, daß der zweite Eingang des Differenzverstärkers über einen zweiten Kondensator und eine Umschaltanordnung an eine Referenzspannungsquelle angeschlossen ist,
daß Schalter der Umschaltanordnung während der beiden Zeitdauern abwechselnd den zweiten Kondensator mit der Referenzspannungsquelle verbinden, und
daß der Ausgang des Differenzverstärkers während der ersten Zeitdauer zusätzlich mit dem zweiten Eingang verbunden ist.

Bei der erfindungsgemäßen Schaltung wird während der ersten Zeitdauer dem ersten Kondensator das erste Eingangssignal und dem zweiten Kondensator eine Referenzspannung über die Umschaltanordnung zugeführt. Der Ausgang ist mit dem ersten Eingang und dem zweiten Eingang verbunden. An dem zweiten Kondensator, der die gleiche Kapazität wie der erste aufweist, liegt eine Spannung, die der Summe der Referenzspannung und der Spannung entspricht, die sich durch die Verbindung des zweiten Eingangs mit dem Ausgang des Differenzverstärkers am zweiten Eingang einstellt. Während der zweiten Zeitdauer wird die Umschaltanordnung umgeschaltet, damit die gleichen Schaltvorgänge wie an der Schalteranordnung vorliegen. Am zweiten Kondensator liegt während der ersten Zeitdauer und während der zweiten Zeitdauer immer die gleiche Referenzspannung an. Daher liegt der zweite Eingang immer am gleichen Bezugspotential. Dieses Bezugspotential wird jedoch durch die Kanalladungsverluste der durch MOS-Feldeffekttransistoren gebildeten Umschaltanordnung verändert.

Die zusätzliche Spannung an dem ersten Kondensator, die durch den Ladungsabfluß der durch MOS-Transistoren gebildeten Schalteranordnung hervorgerufen wird, und die zusätzliche Spannung an dem zweiten Kondensator, die durch den Ladungsabfluß der Umschaltanordnung hervorgerufen wird, sind unter der Voraussetzung, daß annähernd identische Transistoren vorliegen, dem Betrage und der Phase nach gleich. Den beiden Eingängen des Differenzverstärkers werden also Spannungen zugeführt, die sich auf gleiche Weise ändern. Da ein Differenzverstärker eine hohe Gleichtaktunterdrückung aufweist, haben diese zusätzlichen Spannungen wenig Einfluß auf das Ausgangssignal des Differenzverstärkers und können daher keinen fehlerhaften Vergleich bewirken.

Der Differenzverstärker weist zwei Ausgangsanschlüsse auf, die beispielsweise durch einen Stromspiegel verbunden werden können und eine auf Masse bezogene Differenzspannung an eine nachfolgende Schaltung weiterleiten. Die Ausgangsanschlüsse können auch direkt mit der nachfolgenden Schaltung verbunden sein. Diese zweite Möglichkeit sollte bevorzugt verwendet werden, da bei einem Gleichspannungs-Offset des Differenzverstärkers dieser möglicherweise außerhalb seines linearen Bereiches arbeitet.

Es sei noch erwähnt, daß aus der Druckschrift "Electronics Letters", 13. März 1986, Vol. 22, Nr. 6, Seiten 338 bis 339 ebenfalls eine Vergleichsschaltung bekannt ist, bei welcher der nichtinvertierende Eingang und der invertierende Eingang eines Differenzverstärkers über jeweils einen Kondensator mit jeweils zwei unterschiedlich getakteten, als MOS-Transistoren ausgebildeten Schaltern verbunden sind. Die Eingangsanschlüsse der mit dem gleichen Takt betriebenen Schalter sind zusammengeschaltet. Die Schalter, die während einer ersten Zeitdauer geschlossen sind, erhalten die umzusetzende Eingangsspannung und die beiden anderen Schalter die Vergleichsspannung.

Aus der US-A-4,450,368 ist eine Vergleichsschaltung zum Vergleich zweier Eingangsspannungen mittels eines Differenzverstärkers bekannt, bei der ebenfalls in Serie mit jedem der Eingänge des Differenzverstärkers je ein Kondensator vorgesehen ist. Sowohl der erste als auch der zweite Eingang dieses Differenzverstärkers werden während desselben, auch die Beaufschlagung der Eingänge beeinflussenden Zeitintervalls mit dem Verstärkerausgang verbunden.

Bei der erfindungsgemäßen Vergleichsschaltung wird dem zweiten Eingang eine Bezugsspannung zugeführt und nicht abwechselnd die Eingangsspannung und die Vergleichsspannung. Hierdurch muß die erfindungsgemäße Vergleichsschaltung nicht nach jedem Vergleich eines Bits den Ausgang mit seinen beiden Eingängen verbinden, wie dies bei der Schaltung der Druckschrift notwendig ist. Die Eingangs-Ausgangs-Verbindung ist nur zu Beginn des Umsetzungsprozesses bei der erfindungsgemäßen Schaltung notwendig. Durch die Erfindung wird also die Umsetzzeit bei Verwendung der Vergleichsschaltung in einem Analog-Digital-Umsetzer verkürzt.

Eine Weiterbildung der Erfindung besteht darin, daß ein erster Schalter vorgesehen ist, der während der ersten Zeitdauer geschlossen ist und die erste Eingangsspannung an den ersten Anschluß des ersten Kondensators legt, und daß ein zweiter Schalter vorgesehen ist, der mit dem ersten Schalter die Schalteranordnung bildet und der während der zweiten Zeitdauer geschlossen ist und die zweite Eingangsspannung an den ersten Anschluß des ersten Kondensators legt,
daß der erste Eingang des hochohmige Eingänge aufweisenden Differenzverstärkers mit dem zweiten Anschluß des ersten Kondensators und über einen während der ersten Zeitdauer geschlossenen dritten Schalter mit dem Ausgang des Differenzverstärkers gekoppelt ist,
daß der zweite Eingang des Differenzverstärkers über den zweiten Kondensator mit einem vierten und fünften Schalter gekoppelt ist, welche die Umschaltanordnung bilden und welche beide an die Referenzspannungsquelle angeschlossen sind, und
daß der vierte Schalter sowie ein sechster Schalter, der den Aüsgang des Differenzverstärkers mit dem zweiten Eingang verbindet, während der ersten Zeitdauer geschlossen sind und daß der fünfte Schalter während der zweiten Zeitdauer geschlossen ist. Die zusätzliche Spannung am Kondensator wird durch den Ladungsabfluß des ersten Schalters und die zusätzliche Spannung am zweiten Kondensator wird durch den Ladungsabfluß des vierten Schalters hervorgerufen. Die sich auf gleiche Weise ändernden Spannungen durch den Ladungsabfluß des ersten und des vierten Schalters werden durch die Gleichtaktunterdrückung des Differenzverstärkers kompensiert.

Die Schalter in der Vergleichsschaltung werden durch die Parallelschaltung der Drain-Source-Strecke eines N-Kanal-MOS-Feldeffekttransistors und der Drain-Source-Strecke eines P-Kanal-MOS-Feldeffekttransistors gebildet. Gesteuert werden diese Transistoren, indem dem Gate-Anschluß des N-Kanal-Transistors ein Schaltsignal und dem Gate-Anschluß des P-Kanal-Transistors ein invertiertes Schaltsignal zugeführt wird.

Anhand der Zeichnungen werden im folgenden Ausführungsbeispiele der Erfindung erläutert. Es zeigen:
Fig. 1 ein Prinzipschaltbild eines Analog-Digital-Umsetzers, der nach dem Prinzip der sukzessiven Approximation arbeitet,
Fig. 2 eine erfindungsgemäße Vergleichsschaltung und
Fig. 3 eine detailliertere Ausführung der Schaltung gemäß Fig. 2 und
Fig. 4 eine weitere erfindungsgemäße Vergleichsschaltung.

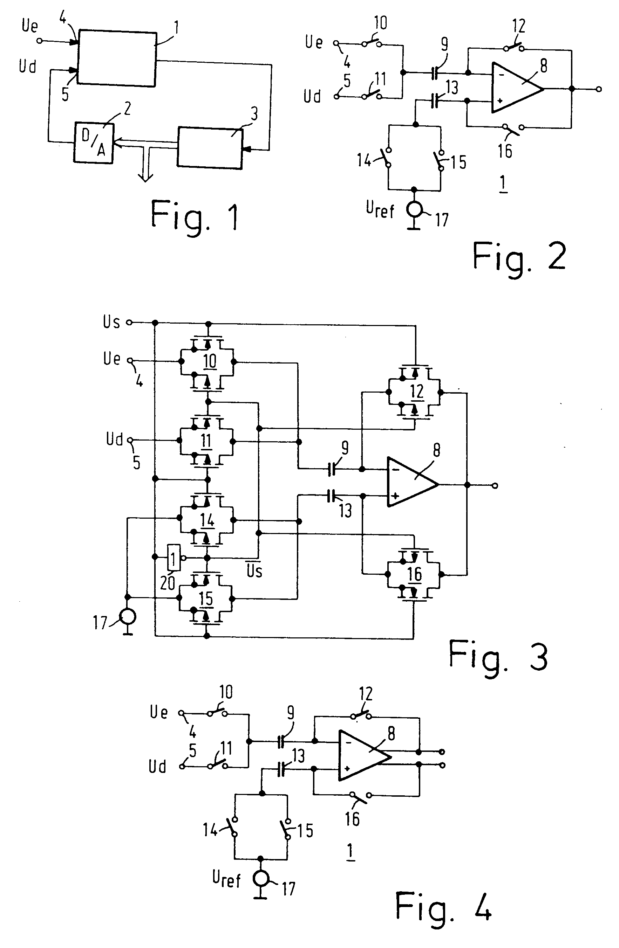

In Fig. 1 ist ein Analog-Digital-Umsetzer dargestellt, der nach dem Prinzip der sukzessiven Approximation arbeitet und der eine Vergleichsschaltung 1, einen Digital-Analog-Umsetzer 2 und eine Steuerschaltung 3 enthält. Die umzusetzende analoge Eingangsspannung Ue wird einem Eingang 4 der Vergleichsschaltung 1 zugeführt, die an ihrem anderen Eingang 5 eine zweite Eingangsspannung Ud vom Digital-Analog-Umsetzer 2 erhält. Die Steuerschaltung 3 setzt zu Beginn eines Umsetzungsprozeß das höchstwertige Bit, das im Digital-Analog-Umsetzer 2 in eine analoge Spannung umgesetzt wird. Die Vergleichsschaltung vergleicht die analoge Eingangsspannung Ue am Eingang 4 mit der vom Digital-Analog-Umsetzer 2 gelieferten analogen Spannung Ud. Ist die vom Digital-Analog-Umsetzer 2 gelieferte Spannung Ud kleiner als die analoge Eingangsspannung Ue am Eingang 4, bleibt das höchstwertige Bit gesetzt, ist die analoge Spannung Ud des Digital-Analog-Umsetzers 2 jedoch größer, wird das höchstwertige Bit zurückgesetzt. Nach diesem ersten Vergleich wird der Vergleich mit dem nächstfolgenden Bit durchgeführt, d.h. die Steuerschaltung 3 setzt das nächste Bit. Auf diese Weise wird schrittweise das digitale Ausgangssignal der Steuerschaltung 3 der analogen Eingangsspannung Ue am Eingang 4 der Vergleichsschaltung 1 angenähert.

In Fig. 2 ist ein Ausführungsbeispiel der erfindungsgemäßen Vergleichsschaltung 1 dargestellt. Die Vergleichsschaltung 1 enthält einen Differenzverstärker 8, dessen invertierender hochohmiger Eingang mit einem Anschluß eines ersten Kondensators 9 verbunden ist. Zwischen dem Eingang 4, dem die analoge Eingangsspannung Ue zugeführt wird, und dem anderen Anschluß des Kondensators 9 liegt ein erster Schalter 10. An dem anderen Anschluß des ersten Kondensators 9 ist noch ein zweiter Schalter 11 angeschlossen, der vom Eingang 5 die Ausgangsspannung Ud des Digital-Analog-Umsetzers 2 erhält. Zwischen dem invertierenden Eingang und dem Ausgang des Differenzverstärkers 8 ist noch ein dritter Schalter 12 angeschlossen.

Der nichtinvertierende hochohmige Eingang des Differenzverstärkers 8 ist mit einem Anschluß eines zweiten Kondensators 13 verbunden, dessen anderer Anschluß über einen vierten Schalter 14 und einen dazu parallel-geschalteten fünften Schalter 15 mit einer Referenzspannungsquelle 17 gekoppelt ist. Der zweite Kondensator 13 weist die gleiche Kapazität auf wie der erste Kondensator 9. Zwischen dem nichtinvertierenden Eingang des Differenzverstärkers 8 und seinem Ausgang liegt ein sechster Schalter 16.

Ein Vergleichsvorgang wird folgendermaßen durchgeführt. Während einer ersten Zeitdauer sind die Schalter 10, 12, 14 und 16 geschlossen. Am Kondensator 9 stellt sich dann eine Spannung ein, die aus der Differenz zwischen der analogen Eingangsspannung Ue und der Spannung, die am invertierenden Eingang des Differenzverstärkers 8 bei geschlossenem Schalter 12 vorliegt, besteht. Die Spannung am Kondensator 13 besteht aus der Differenz der Referenzspannung Uref der Referenzspannungsquelle 17 und der Spannung, die sich am nichtinvertierenden Eingang des Differenzverstärkers 8 bei geschlossenem Schalter 16 einstellt. Das Schließen der Schalter 12 und 16 dient zur Arbeitspunkteinstellung des Differenzverstärkers.

Während einer auf die erste Zeitdauer folgenden zweiten Zeitdauer sind die Schalter 11 und 15 geschlossen und die Schalter 10, 12, 14 und 16 geöffnet. Am Kondensator 9 stellt sich dann eine Spannung ein, die aus der Summe der Ausgangsspannung Ud des Digital-Analog-Umsetzers 2 und der während der ersten Zeitdauer eingestellten Spannung besteht. Am Kondensator 13 liegt eine Spannung an, die sich aus der Summe der Referenzspannung Uref und der während der ersten Zeitdauer eingestellten Spannung bildet. Da während der ersten und zweiten Zeitdauer am Eingangsanschluß des Kondensators 13 jeweils die Referenzspannung Uref anliegt, ist die Spannung am Kondensator 13 während der zweiten Zeitdauer gleich der Spannung, die sich durch das Schließen des Schalters 16 am nichtinvertierenden Eingang des Differenzverstärkers 8 während der ersten Zeitdauer einstellt.

Der Differenzverstärker 8 weist eine so hohe Verstärkung auf, daß seine Ausgangsspannung in Abhängigkeit von der Eingangsspannung an seinen beiden Eingängen entweder einen hohen oder niedrigen Spannungszustand annimmt. Der Spannungszustand der Ausgangsspannung des Differenzverstärkers 8 wird also durch die Differenz der analogen Eingangsspannung Ue und der Spannung Ud des Digital-Analog-Umsetzers 2 bestimmt.

Die Schalter 10 bis 12 und 14 bis 16 bestehen jeweils wenigstens aus einem MOS-Feldeffekttransistor. Solche Transistoren stellen keine idealen Schalter dar. Wenn die Schalter geöffnet sind, d.h. die Transistoren leitend sind, wird eine Ladung im Kanal des Transistors gespeichert. Wenn ein Schalter geöffnet wird, d.h. der Transistor gesperrt wird, findet ein Ladungsabfluß vom Kanal des Transistors statt. Während der zweiten Zeitdauer fließen also Kanalladungen der Schalter 10 und 12 in den Kondensator 9 und Kanalladungen der Schalter 14 und 16 in den Kondensator 13. Unter der Voraussetzung, daß die Schalter mit identischen Transistoren aufgebaut sind, werden in den Kondensatoren 9 und 13 Ladungen gespeichert, die eine Spannung an dem nichtinvertierenden und invertierenden Eingang hervorrufen, die im wesentlichen den gleichen Betrag und die gleiche Phase aufweisen.

Die Gleichtaktspannungen am invertierenden und nichtinvertierenden Eingang des Differenzverstärkers 8, die durch Kanalladungen der Schalter 10, 12, 14 und 16 hervorgerufen werden, werden im wesentlichen unterdrückt, da ein Differenzverstärker eine hohe Gleichtaktunterdrückung aufweist.

Ein etwas detaillierteres Ausführungsbeispiel der Vergleichsschaltung gemäß der Fig. 2 ist in Fig. 3 dargestellt. Die Schalter 10 bis 12 und 14 bis 16 werden jeweils durch einen N-Kanal-MOS-Feldeffekttransistor und einen P-Kanal-MOS-Feldeffekttransistor realisiert. Die Feldeffekttransistoren sind selbstsperrend (Anreicherungstyp). Die Source-Drain-Strecken der beiden Tansistoren sind jeweils parallel geschaltet. Den Gate-Anschlüssen der N-Kanal-Transistoren der Schalter 10, 12, 14 und 16 und den P-Kanal-Transistoren der Schalter 11 und 15 wird ein Schaltsignal Us zugeführt. Ein invertiertes Schaltsignal Us wird den N-Kanal-Transistoren der Schalter 11 und 15 und den P-Kanal-Transistoren der Schalter 10, 12, 14 und 16 zugeführt. Das invertierte Schaltsignal Us wird mit Hilfe eines Inverters 20 hergestellt, der das Schaltsignal Us erhält.

Die in den Fig. 2 und 3 dargestellte Vergleichsschaltung weist einen Differenzverstärker 8 auf, dessen Ausgang durch einen Ausgangsanschluß gebildet wird. Die beiden Ausgangsanschlüsse des Differenzverstärkers 8 sind beispielsweise durch einen nicht dargestellten Stromspiegel miteinander verbunden. Bei einem Gleichspannungs-Offset des Differenzverstärkers 8 besteht die Möglichkeit, daß dieser außerhalb seines linearen Bereiches arbeitet.

Um dies zu verhindern, wird der Differenzverstärker 8, wie das in Fig. 4 dargestellt ist, so betrieben, daß seine beiden Ausgangsanschlüsse direkt an die Steuerschaltung 3 angeschlossen werden. Die Spannungen an den beiden Ausgangsanschlüssen können sich dann beim Schließen der Schalter 12 und 16 nicht gegenseitig beeinflussen und somit nicht den Differenzverstärker 8 in einen Arbeitsbereich bringen, der außerhalb des linearen Arbeitsbereiches liegt.

## Patentansprüche

1. Vergleichsschaltung in MOS-Technik zum Vergleich zweier Eingangsspannungen mittels eines Differenzverstärkers (8),
- dessen erstem Eingang über einen ersten Kondensator (9) mittels einer Schalteranordnung (10, 11) während einer ersten Zeitdauer eine erste Eingangsspannung (Ue) und während einer auf die erste Zeitdauer folgenden zweiten Zeitdauer eine zweite Eingangsspannung (Ud) zugeführt wird,
- dessen zweiter Eingang an einer Bezugsspannung liegt und
- dessen Ausgang während der ersten Zeitdauer mit dem ersten Eingang verbunden ist,
**dadurch gekennzeichnet,** daß der zweite Eingang des Differenzverstärkers (8) über einen zweiten Kondensator (13) und eine Umschaltanordnung an eine Referenzspannungsquelle (17) angeschlossen ist, daß Schalter (14, 15) der Umschaltanordnung während der beiden Zeitdauern abwechselnd den zweiten Kondensator (13) mit der Referenzspannungsquelle (17) verbinden und daß der Ausgang des Differenzverstärkers (8) während der ersten Zeitdauer zusätzlich mit dem zweiten Eingang verbunden ist.

2. Vergleichsschaltung nach Anspruch 1,
**dadurch gekennzeichnet,**
daß ein erster Schalter (10) vorgesehen ist, der während der ersten Zeitdauer geschlossen ist und die erste Eingangsspannung (Ue) an den ersten Anschluß des ersten Kondensators (9) legt, und daß ein zweiter Schalter (11) vorgesehen ist, der mit dem ersten Schalter (10) die Schalteranordnung bildet und der während der zweiten Zeitdauer geschlossen ist und die zweite Eingangsspannung (Ud) an den ersten Anschluß des ersten Kondensators (9) legt,
daß der erste Eingang des hochohmige Eingänge aufweisenden Differenzverstärkers (8) mit dem zweiten Anschluß des ersten Kondensators (9) und über einen während der ersten Zeitdauer geschlossenen dritten Schalter (12) mit dem Ausgang des Differenzverstärkers (8) gekoppelt ist,
daß der zweite Eingang des Differenzverstärkers (8) über den zweiten Kondensator (13) mit einem vierten und fünften Schalter (14, 15) gekoppelt ist, welche die Umschaltanordnung bilden und welche beide an die Referenzspannungsquelle (17) angeschlossen sind, und
daß der vierte Schalter (14) sowie ein sechster Schalter (16), der den Ausgang des Differenzverstärkers (8) mit dem zweiten Eingang verbindet, während der ersten Zeitdauer geschlossen sind und daß der fünfte Schalter (15) während der zweiten Zeitdauer geschlossen ist.

3. Vergleichsschaltung nach Anspruch 2,
**dadurch gekennzeichnet,** daß die Schalter (10 bis 16) durch die Parallelschaltung der Drain-Source-Strecke eines N-Kanal-MOS-Feldeffekttransistors und der Drain-Source-Strecke eines P-Kanal-MOS-Feldeffekttransistors gebildet sind und daß der Gate-Anschluß des N-Kanal-Transistors ein Schaltsignal und der Gate-Anschluß des P-Kanal-Transistors ein invertiertes Schaltsignal erhält.

## Claims

1. A comparison circuit in MOS technology for comparing two input voltages by means of a differential amplifier (8)
- having a first input to which a first input voltage (Ue) is applied during a first time interval and a second input voltage (Ud) during a second time interval succeeding the first time interval by means of a switch arrangement (10, 11) *via* a first capacitor (9),
- having a second input connected to a reference voltage, and
- having an output connected to the first input during the first time interval,
**characterized in that** the second input of the differential amplifier (8) is connected to a reference voltage source (17) *via* a second capacitor (13) and a switching device, switches (14, 15) of the switching device (14,15) alternately connect the second capacitor (13) to the reference voltage source (17) during the two time intervals, and the output of the differential amplifier (8) is additionally connected to the second input during the first time interval.

2. A comparison circuit as claimed in Claim 1, **characterized in that** there is provided a first switch (10), which is closed during the first time interval and which applies the first input voltage (Ue) to the first terminal of the first capacitor (9), and there is provided a second switch (11), which in conjunction with the first switch (10) constitutes the switch arrangement, which second switch is closed during the second time interval and applies the second input voltage (Ud) to the first terminal of the first capacitor (9), the first input of the differential amplifier (8), which has high-impedance inputs, is coupled to the second terminal of the first capacitor (9) and, *via* a third switch (12) which is closed during the first time interval, to the output of the differential amplifier (8), the second input of the differential amplifier (8) is coupled to a fourth and a fifth switch (14, 15) *via* the second capacitor (13), which fourth and fifth switch constitute the switching device and are both connected to the reference voltage source (17), and the fourth switch (14) and a sixth switch (16), which connects the output of the differential amplifier (8) to the second input, are closed during the first time interval and the fifth switch (15) is closed during the second time interval.

3. A comparison circuit as claimed in Claim 2, **characterized in that** the switches (10 to 16) are constituted by the parallel arrangement of the drain-source path of an N-channel MOS field-effect transistor and the drain-source path of a P-channel MOS field-effect transistor, and the gate connection of the N-channel transistor receives a switching signal and the gate connection of the P-channel transistor receives an inverted switching signal.

## Revendications

1. Circuit de comparaison en technique MOS pour comparer deux tensions d'entrée au moyen d'un amplificateur de différence (8),
- dont la première entrée reçoit via un premier condensateur (9), au moyen d'un dispositif d'interruption (10, 11), pendant une première période de temps, une première tension d'entrée (Ue) et, pendant une deuxième période de temps qui suit la première, une seconde tension d'entrée (Ud),
- dont la seconde entrée reçoit une tension de référence, et
- dont la sortie est connectée à la première entrée pendant la première période de temps,
caractérisé en ce que la seconde entrée de l'amplificateur de différence (8) est connectée par l'intermédiaire d'un second condensateur (13) et d'un dispositif de commutation à une source de tension de référence (17),
que des interrupteurs (14,15) du dispositif de commutation relient pendant les deux périodes de temps, alternativement le second condensateur (13) à la source de tension de référence (17), et
que la sortie de l'amplificateur de différence (8) est reliée pendant la première période de temps, en outre, à la seconde entrée.

2. Circuit de comparaison suivant la revendication 1, caractérisé en ce qu'un premier interrupteur (10) est prévu qui, pendant la première période de temps, est fermé et qui applique la première tension d'entrée (Ue) à la première connexion du premier condensateur (9), et qu'un second interrupteur (11) est prévu qui forme le dispositif d'interruption avec le premier interrupteur (10) et qui, pendant la seconde période de temps, est fermé et applique la seconde tension d'entrée (Ud) à la première connexion du premier condensateur (9),
que la première entrée de l'amplificateur de différence (8) comportant des entrées à haute valeur ohmique est couplée à la deuxième connexion du premier condensateur (9) et via un troisième interrupteur (12) fermé pendant la première période de temps à la sortie de l'amplificateur de différence (8),
que la seconde entrée de l'amplificateur de différence (8) est couplée par l'intermédiaire du second condensateur (13) à un quatrième et à un cinquième interrupteur (14, 15) qui forment le dispositif de commutation et qui sont connectés tous deux à la source de tension de référence (17), et
que le quatrième interrupteur (14) de même qu'un sixième interrupteur (16), qui relie la sortie de l'amplificateur de différence (8) à la deuxième entrée, est fermé pendant la première période de temps et que le cinquième interrupteur est fermé pendant la deuxième période de temps.

3. Circuit de comparaison suivant la revendication 2, caractérisé en ce que les interrupteurs (10 à 16) sont formés par le montage en parallèle du trajet drain-source d'un transistor à effet de champ MOS à canal N et du trajet drain-source d'un transistor à effet de champ MOS à canal P et que la connexion de grille du transistor à canal N reçoit un signal de commutation et la connexion de grille du transistor à canal P, un signal de commutation inversé.
